## Europäisches Patentamt

## European Patent Office

## Office européen des brevets

(19)

(11) Veröffentlichungsnummer: **0 155 391**
**B1**

# EUROPÄISCHE PATENTSCHRIFT

(12)

(45) Veröffentlichungstag der Patentschrift:
**13.09.89**

(21) Anmeldenummer: **84115437.0**

(22) Anmeldetag: **14.12.84**

(51) Int. Cl.⁴: **G 01 R 1/20**

(54) **Anordnung zum Messen von elektrischen Strömen unter Verwendung eines Magnetfeldsensors.**

(30) Priorität: **07.01.84 DE 8400275 U**

(43) Veröffentlichungstag der Anmeldung:
**25.09.85 Patentblatt 85/39**

(45) Bekanntmachung des Hinweises auf die Patenterteilung:
**13.09.89 Patentblatt 89/37**

(84) Benannte Vertragsstaaten:
**DE FR GB**

(56) Entgegenhaltungen:
**EP-A-0 082 082**
**DD-A-155 220**
**US-A-4 362 990**

(73) Patentinhaber: **DODUCO KG. Dr. Eugen Dürrwächter, Im Altgefäll 12 Postfach 480, D-7530 Pforzheim (DE)**

(72) Erfinder: **Schulze, Gunter, Dipl.- Ing., Lutherstrasse 3, D-7536 Ispringen (DE)**

(74) Vertreter: **Twelmeier, Ulrich, Dipl.Phys., Patentanwälte Dr. Rudolf Bauer Dipl.-Ing.Helmut Hubbuch, Dipl.Phys. Ulrich Twelmeier Westliche Karl- Friedrich- Strasse 29-31, D-7530 Pforzheim (DE)**

## Beschreibung

Die Erfindung geht aus von einer Anordnung mit den im Oberbegriff des Anspruchs 1 angegebenen Merkmalen. Eine solche Anordnung ist aus der EP-A-0 082 082 bekannt. Es handelt sich bei dem Magnetfeldsensor um eine Induktionsspule, welche von einem Stromleiter in Gestalt einer U-förmigen Schelle umschlungen ist. Im Innern der Schelle erzeugt der elektrische Strom, welcher durch die Schelle hindurch fließt, ein weitgehend homogenes Magnetfeld, dessen Stärke der Stromstärke direkt proportional ist. Das Magnetfeld induziert in die Spule eine Spannung, welche der Stromstärke in der Schelle proportional ist und in üblicher Weise gemessen werden kann. Die Schelle hat jedoch nicht nur die Aufgabe, den elektrischen Strom um die Spule herumzuführen, sie hat die weitere Aufgabe, die Spule auf einem Träger zu befestigen. Zum Befestigen dienen zwei in entgegengesetzte Richtungen weisende Enden der im übrigen U-förmigen Schelle.

Die Messanordnung hat einen geringen Ohmschen Innenwiderstand, welcher durch den Widerstand der Schelle bestimmt ist, und der Meßeingang der Anordnung (das sind die Anschlußpunkte der Schelle) und der Meßausgang der Anordnung (das sind die beiden Anschlußpunkte der Spule, an welchen die Induktionsspannung abgegriffen wird) sind galvanisch vollständig voneinander getrennt.

Um den Magnetfeldsensor gegen störende äussere Magnetfelder abzuschirmen, steckt er in einem Gehäuse, welches teils aus isolierendem Kunststoff und teils aus ferromagnetischem Werkstoff besteht.

Nachteilig bei dieser bekannten Anordnung ist, dass sie eine Induktivität und damit einen Blindwiderstand aufweist, die die Meßgenauigkeit durch eine nicht abschirmbare Gegeninduktion beeinflußt.

Andererseits sind Magnetfeldsensoren bekannt, welche in einem zylindrischen oder teilzylindrischen, sich durch einen achsparallelen ebenen Abschnitt von der Zylindergestalt unterscheidenden Gehäuse eine Wheatstonebrücke aus vier magnetfeldempfindlichen Widerständen enthalten, welche derart angeordnet sind, dass die empfindliche Achse des Magnetfeldsensors die Längsachse des Zylinders oder eine dazu parallele Achse ist.

Derartige Magnetfeldsensoren sind bekannt und z. B. beschrieben in der Firmenschrift

"Philips Technical publication 102,
The magnetoresistive sensor"

auf welche hiermit Bezug genommen wird. Diese Druckschrift zeigt einen Magnetfeldsensor in einem teilzylindrischen Gehäuse, welches sich von einem exakt zylindrischen Gehäuse dadurch unterscheidet, dass durch einen Abschnitt eines Teils des Zylinders eine achsparallele ebene Fläche gebildet ist. Bei diesem bekannten Magnetfeldsensor ist die empfindliche Achse die Längsachse des Zylinders, d.h., dieser Magnetfeldsensor reagiert auf Änderungen eines Magnetfeldes, dessen Feldstärke die Richtung der empfindlichen Achse hat, mit einer Verstimmung der Wheatstonebrücke.

In dieser Druckschrift findet sich auch bereits ein Hinweis, dass man mit dem Magnetfeldsensor das Fließen von elektrischem Strom überwachen kann, z. B. zur Überwachung der Funktion von Scheinwerfern in Fahrzeugen. Angaben darüber, wie das im Einzelnen geschehen soll, finden sich in dieser Druckschrift nicht.

Der Erfindung liegt die Aufgabe zugrunde, eine Anordnung der eingangs genannten Art zum Messen von elektrischen Strömen zu schaffen, die keine Induktivität aufweist, auf einfache Weise vor störenden äußeren Magnetfeldern abgeschirmt sowie möglichst preiswert und für eine Massenfertigung gut geeignet ist.

Diese Aufgabe wird gelöst durch eine Anordnung mit den im Anspruch 1 angegebenen Merkmalen. Vorteilhafte Weiterbildungen der Erfindung sind Gegenstand der Unteransprüche.

Die erfindungsgemäße Anordnung weist praktisch keine störende Induktivität auf, denn der Magnetfeldsensor enthält keine Spule und der Stromleiter bildet keine geschlossene Windung um den Magnetfeldsensor herum, sondern stellt ein an den Füßen des Ω offenes Gebilde dar.

Durch die Ω-förmige Schelle kann in vorteilhafter Weise der Magnetfeldsensor zugleich gegen magnetische Störfelder abgeschirmt werden. Um dies zu erreichen, kann man die Schelle aus ferromagnetischem Werkstoff herstellen, z. B. durch Biegen eines ferromagnetischen Bleches in eine Ω-förmige Gestalt. Eine andere Möglichkeit besteht darin, eine aus einem Kupferblech gebogene, Ω-förmige Schelle auf ihrer Aussenseite mit einem ferromagnetischen Werkstoff zu beschichten.

Die Meßempfindlichkeit der Anordnung kann in gewissen Grenzen beeinflußt werden durch die Wahl der Breite der Ω-förmigen Schelle. Eine andere Art der Beeinflussung der Empfindlichkeit der Meßanordnung besteht darin, dass man die Schelle als Schichtkörper ausbildet, in welchem zwischen je zwei elektrisch gut leitenden Schichten eine elektrisch isolierende Schicht angeordnet ist. Dieser Schichtkörper kann obendrein - vorzugsweise auf seiner Aussenseite - zur Abschirmung des Magnetfeldsensors gegen magnetische Störfelder eine Schicht aus ferromagnetischem Werkstoff aufweisen. Die elektrisch leitenden Schichten der Ω-förmigen Schelle können in unterschiedlicher Weise elektrisch miteinander verbunden werden. Verbindet man sie parallel miteinander, dann erhält man eine Meßanordnung, welche sich bei geringerer Empfindlichkeit eher für das Messen großer Ströme eignet. Verbindet man die elektrisch leitenden Schichten hingegen in Reihe, dann erhält man eine Meßanordnung, welche sich eher für kleine Stromstärken eignet, dafür eine größere Empfindlichkeit besitzt. Die Art und Weise der Verbindung der elektrisch leitenden Schichten der Schelle kann grundsätzlich vom Hersteller gewählt und vorgegeben sein, sie kann aber auch dem Anwender überlassen bleiben. Zweckmässigerweise erfolgt die elektrische Verbindung der Schichten über den Träger, auf welchem die Meßanordnung mittels der Schelle befestigt wird. Sie kann aber auch - insbesondere bei einer Parallelschaltung der Schichten - an der Schelle selbst erfolgen. In jedem Fall ist bei der Verbindung darauf zu achten, dass durch die Verbindung keine den Magnetfeldsensor völlig umschließende Strombahn gebildet wird, welche eine störende Induktivität nach sich ziehen würde.

Die Herstellung von Schichtkörpern für elektrische Zwecke ist Stand der Technik. Für den vorliegenden Anwendungszweck stellt man vorzugsweise zunächst eine sogenannte Multilayer-Folie her, aus welcher man anschließend durch einen Umformschritt Ω-förmige Schellen herstellen kann.

Durch die Ausbildung des Ω-förmigen Stromleiters als Schelle zum Befestigen des Magnetfeldsensors ergibt sich als weiterer Vorteil, dass wegen der guten Fixierung des Magnetfeldsensors mittels der Schelle auf dem Träger (Leiterplatte) die elektrischen Kennwerte der Strommeßanordnung gut reproduzierbar sind, was für einen Massenartikel von großer Bedeutung ist.

Die neuartige Meßanordnung ist unmittelbar einsetzbar zum Messen von Stromstärken bis ungefähr 100 A, und durch Verwendung von Nebenschlußschaltungen können auch höhere Stromstärken gemessen werden. Ferner ist die Meßanordnung verwendbar für Gleichstrom und für Wechselstrom bei Frequenzen bis zu 10 MHz.

Ein Ausführungsbeispiel der Neuerung ist schematisch in den beigefügten Zeichnungen dargestellt.

Figur 1   zeigt eine Meßanordnung für elektrische Ströme in einer Schrägansicht, und

Figur 2   zeigt eine abgewandelte Meßanordnung mit einer als Schichtkörper aufgebauten Schelle bei Blickrichtung in Achsrichtung auf das eine Ende des Magnetfeldsensors.

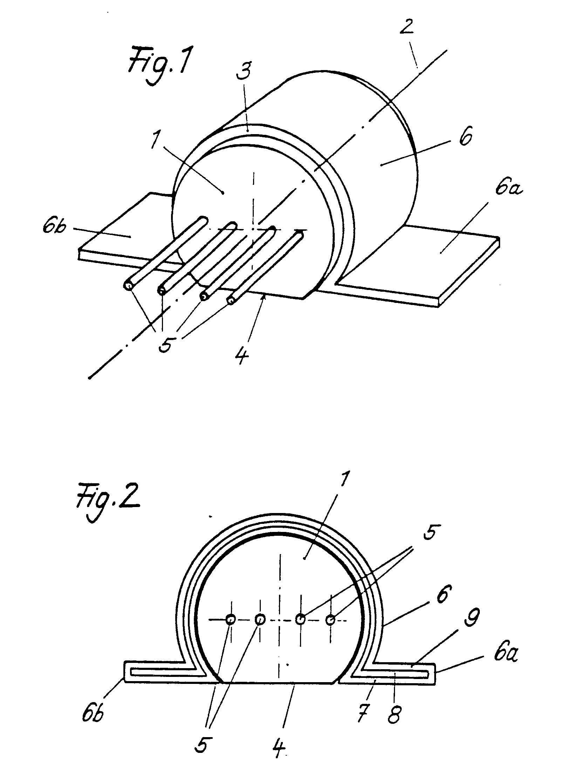

Die in Fig. 1 dargestellte Meßanordnung besteht aus einem teilzylindrischen Magnetfeldsensor 1, dessen Gehäuseform dadurch von der wahren Zylinderform abweicht, dass durch einen parallel zur Zylinderachse 2 geführten Schnitt am Gehäusemantel 3 eine achsparallele, ebene Fläche 4 gebildet ist.

Aus der einen Endfläche des Gehäuses des Magnetfeldsensors 1 führen vier elektrische Anschlußleitungen 5 heraus, welche zu den vier Eckpunkten der Wheatstonebrücke im Innern des Magnetfeldsensors Verbindung haben.

Der Magnetfeldsensor ist umgeben von einer Ω-förmigen Schelle 6, welche den Mantel des Magnetfeldsensors in seinem zylindrischen Bereich eng umschließt und nur die ebene Fläche 4 des Magnetfeldsensors freiläßt. Die beiden in entgegengesetzte Richtungen weisenden Füße 6a und 6b der Schelle dienen zur Zu- und Ableitung des elektrischen Stromes, dessen Stärke gemessen werden soll, sowie zum Befestigen der Meßanordnung auf einem Träger, insbesondere auf einer elektrischen Leiterplatte. Die Füße 6a und 6b können auf dem Träger in üblicher Weise befestigt werden, z. B. durch Vernieten oder Verlöten. Die Schelle besteht im einfachsten Fall aus einem elektrisch leitenden Blech, welches in eine Ω-förmige Gestalt gebogen wurde. Mit Vorteil kann die Schelle auch als Schichtkörper ausgebildet sein. Figur 2 zeigt eine solche Anordnung mit einer Schelle, welche aus zwei elektrisch leitfähigen Schichten 7 und 8 besteht, welche durch eine elektrisch isolierende Zwischenschicht 9 voneinander getrennt sind. Im gezeichneten Beispiel sind die beiden elektrisch leitenden Schichten 7 und 8 parallel miteinander verbunden; die Verbindung ist am Ende der Füße 6a und 6b erfolgt.

## Patentansprüche

1. Anordnung zum Messen von elektrischen Strömen unter Verwendung eines Magnetfeldsensors, welcher gegen äußere Magnetfelder abgeschirmt in einem Gehäuse angeordnet und von einem elektrischen Stromleiter in Gestalt einer Ω-förmigen Schelle umschlungen ist und eine empfindliche Achse aufweist, die mit einer Achse des Gehäuses oder einer dazu parallelen Achse zusammenfällt, dadurch gekennzeichnet, dass der Magnetfeldsensor (1) eine Wheatstonebrücke aus vier magnetfeldempfindlichen Widerständen enthält, dass die Ω-förmige Schelle (6) ganz oder teilweise aus ferromagnetischem Werkstoff besteht, dass das Gehäuse des Magnetfeldsensors (1) zylindrisch oder teilzylindrisch, sich durch einen achsparallelen, ebenen Abschnitt (4) von der Zylindergestalt unterscheidend ausgebildet ist, und dass die empfindliche Achse des Magnetfeldsensors (1) die Längsachse (2) des Zylinders oder eine dazu parallele Achse ist.

2. Anordnung nach Anspruch 1, dadurch gekennzeichnet, dass die Ω-förmige Schelle (6) ein Schichtkörper ist, von dessen Schichten (7, 8, 9) wenigstens eine, vorzugsweise die äußerste (9) der elektrisch leitenden Schichten (7, 9), aus ferromagnetischem Werkstoff besteht.

3. Anordnung nach Anspruch 1 oder 2, dadurch gekennzeichnet, dass die Ω-förmige Schelle (6) ein Schichtkörper ist, in welchem zwischen je zwei elektrisch gut leitenden Schichten (7, 9) eine elektrisch isolierende Schicht (8) angeordnet ist.

## Claims

1. An arrangement for measuring electric currents by means of a magnetic field sensor which is arranged in a housing so as to be shielded from external magnetic fields and a conductor for electric current consisting of an Ω-shaped clip is looped around the sensor, which has a sensitive axis which coincides with an axis of the housing or an axis that is parallel thereto, characterized in that the magnetic field sensor (1) contains a Wheatstone bridge that consists of four resistors which are responsive to magnetic fields, the Ω-shaped clip (6) consists entirely or in part of ferromagnetic material, the housing of the magnetic field sensor (1) is cylindrical or is partly cylindrical and differs from a cylindrical shape by having a planar section (4) which is parallel to the axis, and the sensitive axis of the magnetic field sensor (1) is the longitudinal axis (2) of the cylinder or an axis that is parallel thereto.

2. An arrangement according to claim 1, characterized in that the Ω-shaped clip (6) is a laminate, at least one of the layers (7, 8, 9) of which, preferably the outer one (9) of the electrically conducting layers (7, 9), is made of a ferromagnetic material.

3. An arrangement according to claim 1 or 2, characterized in that the Ω-shaped clip (6) consists of a laminate in which an electrically insulating layer (8) is arranged between adjacent layers (7, 9) having a high electrical conductivity.

## Revendications

1. Dispositif pour mesurer des courants électriques utilisant un capteur de champs magnétique, logé dans un boîtier protégé contre des champs magnétiques extérieurs et entouré d'un conducteur de courant sous forme d'un collier en forme d'Ω et présentant un axe sensible coincidant avec un axe du boîtier ou un axe parallèle à ce dernier, caractérisé en ce que le capteur de champs magnétiques (1) comprend un pont de Wheatstone de quatre résistances sensibles aux champs magnétiques, que le collier en forme d'Ω (6) consiste dans son ensemble ou en partie en matériau ferromagnétique, que le boîtier du capteur de champs magnétiques (1) est cylindrique ou partiellement cylindrique se distinguant de la forme cylindrique par une section (4) plane parallèle à l'axe et que l'axe sensible du capteur de champs magnétiques (1) est l'axe longitudinal (2) du cylindre ou un axe parallèle à ce dernier.

2. Dispositif selon revendication 1, caractérisé en ce que le collier en forme d'Ω est un corps stratifié dont au-moins une des couches (7, 8, 9), de préférence celle de l'extérieur (9), des couches conductrices (7, 9) consiste en un matériaux ferromagnétique.

3. Dispositif selon revendication 1 ou 2, caractérisé en ce que le collier en forme d'Ω (6) est un corps stratifié dans lequel une couche (8) électriquement isolante est disposée entre deux couches (7, 9) de très bonne conductivité.

_Fig.1_

_Fig.2_